# FASCICULE DE BREVET EUROPEEN

(11) **EP 1 186 683 B1**
(45) Date de publication et mention de la délivrance du brevet: **30.11.2005**
(21) Numéro de dépôt: 00810792.2
(22) Date de dépôt: 04.09.2000
(51) Int. Cl.: C23C 14/48

(54) **Procédé de durcissement de la surface d'un substrat**
Verfahren zur Härtung von Oberflächen eines Substrats
Process of surface hardening of a substrate

(43) Date de publication de la demande: 13.03.2002
(73) Titulaire: CAFI Centre d'analyses par faisceau ionique, 2400 Le Locle (CH)
(72) Inventeur: Jaccard, Samuel, 2400 Le Locle (CH); Mikhailov, Serguei, 2000 Neuchâtel (CH)
(74) Mandataire: Ritscher, Thomas

(56) Documents cités:
- EP-A- 0 718 417
- US-A- 5 662 999
- US-A- 5 695 832
- WALTER K C ET AL: "Adherent diamond-like carbon coatings on metals via plasma source ion implantation" THIRD INTERNATIONAL WORKSHOP ON PLASMA-BASED ION IMPLANTATION, DRESDEN, GERMANY, 15-18 SEPT. 1996, vol. 93, no. 2-3, pages 287-291, XP000979608 Surface and Coatings Technology, Sept. 1997, Elsevier, Switzerland ISSN: 0257-8972
- MONTEIRO O R: "Plasma synthesis of hard materials with energetic ions" NUCLEAR INSTRUMENTS & METHODS IN PHYSICS RESEARCH, SECTION - B: BEAM INTERACTIONS WITH MATERIALS AND ATOMS,NL,NORTH-HOLLAND PUBLISHING COMPANY. AMSTERDAM, vol. 148, no. 1-4, 2 janvier 1999 (1999-01-02), pages 12-16, XP004156456 ISSN: 0168-583X

## Description

La présente invention se rapporte aux techniques de traitement des surfaces de matériaux en vue de les durcir et de les rendre auto-lubrifiantes.

L'invention concerne, plus particulièrement, d'une part, un procédé d'obtention d'une pièce dont une surface, au moins, est revêtue d'une couche à base de carbone et, d'autre part, la pièce ainsi obtenue.

L'invention trouve une application très intéressante dans le traitement de pièces utilisées en microtechnique et, spécialement, dans l'horlogerie.

Il existe actuellement de nombreux procédés pour traiter de telles pièces. Le plus connu est le dépôt de carbone amorphe par la technique de CVD (Chemical Vapor Deposition) afin de réaliser une couche de DLC (Diamond Like Carbon).

US 5,662,999 divulgue la matrice d'une forme dont les faces internes sont couvertes par une couche en carbone DLC (diamond like carbon) qui est appliqué soit par une couche intermédiaire sur la face correspondante par voie directe. La couche de carbone est obtenue par dépôt ionique (IBD = Ion Beam Deposition). Cette couche a néanmoins des problèmes dues à une exfoliation.

Walter et al. (Surface and Coatings Technology 93 (1997), 287-291) decrivent la formation d'une couche DLC par implantation ionique en sortant d'un plasma constitué de methane et/ou éthane ce qui résulte dans la formation des couches DLC qui contiennent encore des atomes de carbone avec des liaisons carbone -hydrogène ce qui diminue la dureté de la couche obtenue.

EP 0718 417 A1 divulgue un matériau multicouche comprenant une couche d'interface assurant l'adhérence d'un revêtement mince à base de carbone sur un substrat. Le dépôt de la couche de carbone est effectué par un dépôt physique en phase vapeur.

O. R. Monteiro (Nucl. Instruments and Methods in Physics Res. B 148 (1999) 12-16) décrit la synthèse plasma des matériaux durs, notamment de diamant amorphe.

US 5,695,832 divulgue une méthode de former des couches DLC par une couche intermédiaire sur des substrats avec un plasma généré avec un gaz contentant du carbone.

La présente invention a pour but de proposer un nouveau procédé permettant d'obtenir des pièces qui répondent, mieux que les pièces réalisées par les procédés connus, aux sévères exigences en matière, notamment, de durabilité et de dureté.

Pour atteindre ce but, le procédé selon l'invention consiste à:
- se munir d'un substrat en un matériau présentant une affinité pour le carbone, et alors
- bombarder une face de ce substrat par un faisceau d'ions de carbone accélérés en reduisant progressivement la tension sous laquelle les ions de carbone sont accélérés, pour
   . créer, sous ladite face, une zone d'implantation de carbone présentant un gradient croissant en direction de cette face, puis
   . maintenir la tension d'accélération constante à son niveau réduit pendant une durée suffisante pour faire croître sur la zone d'implantation une couche à base de carbone jusqu'à l'épaisseur désiré.

De façon avantageuse, le procédé selon l'invention présente encore les caractéristiques suivantes:
- le matériau formant le substrat est choisi parmi le fer, le chrome, le titane, le vanadium, le tantale, le tungstène, le molybdène et le nickel, ainsi que leurs oxydes, leurs nitrures et leurs alliages;
- le substrat est en acier, tel que l'acier 20AP;
- le substrat est bombardé à l'aide d'un faisceau d'ions pulsé accéléré;
- le substrat est bombardé à l'aide d'un faisceau d'ions qui est filtré de manière à contenir essentiellement des ions de carbone;
- le substrat est bombardé à partir d'une source d'ions dite à "arc filtré pulsé";
- la zone d'implantation à gradient croissant est créée en faisant varier l'énergie des ions;
- le taux d'implantation varie de 0 % à la base de la zone d'implantation à 100% à sa limite supérieure sensiblement confondue avec la face du substrat;
- la zone superficielle de carbone est créée en maintenant sensiblement constante l'énergie des ions;
- pendant le bombardement du substrat, celui-ci est animé d'un mouvement de rotation;
- le substrat est bombardé par plusieurs faisceaux d'ions le touchant sous des angles différents;

Une pièce réalisée grâce au procédé ci-dessus est caractérisée en ce que:
- la zone d'implantation a une profondeur comprise entre 10 et 100 nm;
- la zone superficielle a une épaisseur inférieure à 300 nm, avantageusement de l'ordre de 100 nm.

D'autres caractéristiques et avantages de la présente invention ressortiront de la description qui va suivre, faite en regard des dessins annexés sur lesquels.
- les figures 1 et 2 montrent un substrat devant être durci, respectivement avant et à la fin de son traitement; et
- la figure 3 représente schématiquement l'équipement utilisé pour la mise en oeuvre de l'invention.

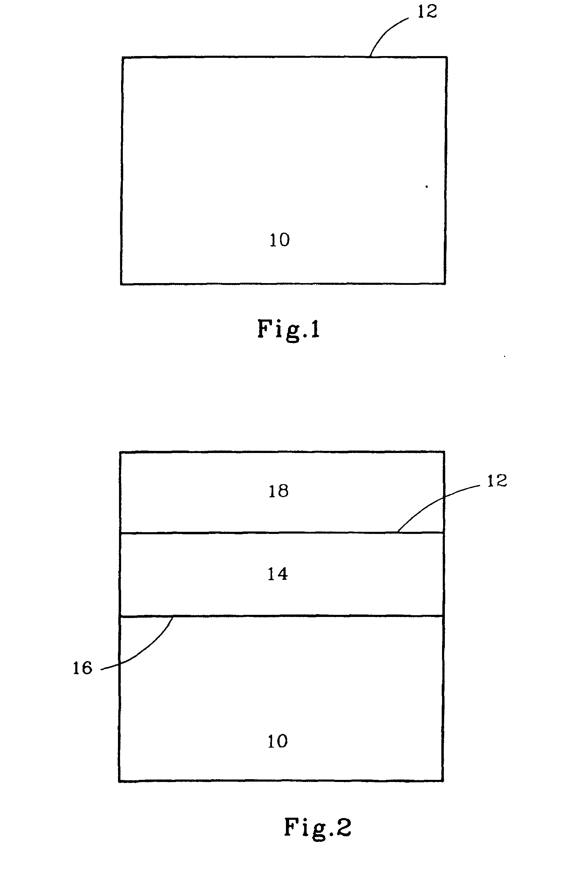

On se référera tout d'abord à la figure 1 qui montre en 10, vu en coupe, un substrat dont la face supérieure 12 doit être durcie et rendue auto-lubrifiante par le dépôt d'une couche à base de carbone.

Le substrat 10 doit être en tout matériau présentant une affinité pour le carbone, tel que le fer, le chrome, le titane, le vanadium, le tantale, le tungstène, le molybdène et le nickel, ainsi que leurs oxydes, leurs nitrures et leurs alliages. De préférence, le substrat est en acier 20AP, alliage communément utilisé dans l'industrie horlogère.

La figure 2 montre le même substrat 10 une fois doté de sa couche de durcissement auto-lubrifiante. On remarque que le substrat possède maintenant une zone d'implantation 14 ayant une profondeur de, typiquement, 10 à 100 nm, dans laquelle ont été formés des carbures du matériau initial. Selon la présente invention, cette zone a la particularité de présenter un gradient d'implantation croissant en direction de la face supérieure 12 du substrat. Le taux d'implantation passe de 0 % de carbure à la limite inférieure 16 de la couche 14 à 100% de carbure à sa limite supérieure confondue avec la face supérieure 12 du substrat.

De plus, cette face supérieure 12 est maintenant recouverte d'une couche superficielle 18 uniquement constituée de carbone sous la forme de carbone amorphe ou de DLC (Diamond Like Carbon). L'épaisseur de cette couche est inférieure à 300 nm et, avantageusement, de l'ordre de 100 nm.

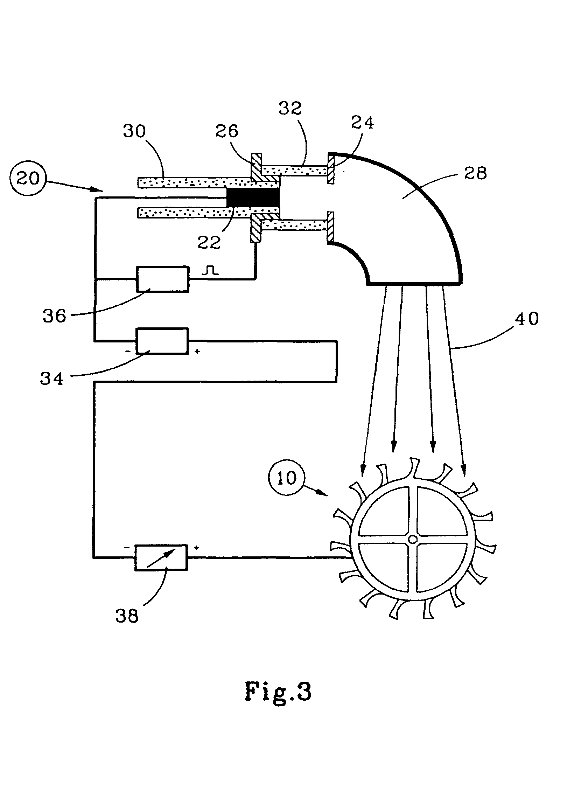

Pour réaliser un tel dépôt, on utilise, selon la présente invention, une source d'ions 20, de préférence à "arc filtré pulsé", qui est représentée schématiquement en 20 sur la figure 3. Une telle source, commercialisée par la firme RHK sous la dénomination "ARC 20 Pulsed Plasma Arc Source" (PPAS), comporte essentiellement une cathode en graphite 22, une anode 24, une grille 26 et un filtre magnétique 28.

La cathode 22, de forme cylindrique, est disposée à l'intérieur d'un manchon isolant 30 sur lequel est fixée la grille 26, en forme d'anneau coaxial à la cathode. Un deuxième manchon isolant 32, fixé sur la grille à une extrémité, supporte, à son autre extrémité, l'anode 24 également en forme d'anneau coaxial à la cathode. Le filtre magnétique 28, fixé sur l'anode, forme un secteur annulaire de 90° à section circulaire.

Sur la figure 3, la pièce à traiter 10 est représentée schématiquement sous la forme d'une roue d'échappement destinée à un mouvement de montre mécanique.

Une première source de tension constante 34 est connectée entre la cathode 22 et l'anode 24. Une deuxième source de tension pulsée 36 est connectée entre la cathode 22 et la grille 26. Enfin, une troisième source de haute tension variable 38 est connectée entre l'anode 24 et la pièce à traiter 10.

En fonctionnement, sous l'effet des tensions délivrées par les sources 34 et 36, les atomes de carbone, émis par la cathode 22 et attirés par l'anode 24 sous le contrôle de la grille 26, débouchent dans le filtre magnétique 28 sous la forme d'un faisceau d'ions pulsé coaxial aux électrodes. On notera, à ce propos, que la source pulsée 36, non seulement, augmente l'efficacité de l'ionisation des atomes de carbone, mais aussi, permet un meilleur contrôle de l'intensité du faisceau d'ions.

Le filtre magnétique 28 a pour effet, selon un processus bien connu, de dévier de 90°, par rapport à leur trajectoire initiale, uniquement les ions de carbone, en éliminant donc d'éventuelles grosses particules résultant de processus d'agglomération inévitables dans une telle source. Ainsi, le filtre magnétique 28 délivre un faisceau très homogène 40 d'ions carbone qui sont alors accélérés, sous l'effet du champ électrique établi par la source de tension 38 entre la sortie du filtre et la pièce à traiter 10, pour venir bombarder celle-ci avec une énergie dépendant de l'intensité de ce champ .

Afin de doter la pièce 10 de son revêtement dur et auto-lubrifiant, tel que décrit en regard de la figure 2, le bombardement de la pièce est effectué en faisant varier, grâce à la tension d'accélération de la source 38, l'énergie du faisceau d'ions 40.

Plus précisément, les ions de carbone sont, tout d'abord, accélérés sous une tension qui est progressivement réduite de, typiquement 2 500 V à 200-100 V, afin de permettre leur implantation et la formation de carbures dans la couche 14 selon un gradient croissant en direction de la face supérieure 12 du substrat, le taux d'implantation passant, comme déjà indiqué, de 0 % à 100% (saturation). La durée pendant laquelle s'effectue la décroissance de la tension d'accélération est, bien entendu, fonction du flux d'ions émis par la source 20. Typiquement, lorsque celle-ci est la source "ARC 20", l'opération d'implantation s'effectue en 30 à 60 minutes, la diminution de la tension d'accélération se faisant de manière sensiblement linéaire.

Pour réaliser ensuite la couche superficielle en carbone 18, il suffit de maintenir la tension d'accélération à son niveau de 200-100 V pendant une durée suffisante, fonction de la source elle-même, pour faire croître la couche jusqu'à l'épaisseur désirée. Typiquement, le temps nécessaire pour obtenir une couche DLC de 100 nm est de 30 à 60 minutes.

La couche de carbone 18 ainsi réalisée est à la fois dure, autolubrifiante, inerte, bio-compatible ainsi que résistante à la corrosion (acides et bases), à l'irradiation et aux températures élevées. A titre indicatif, cette couche présente une dureté de 18 à 25 GPa et un coefficient de frottement contre le rubis qui est inférieur à 0,1 et reste stable dans une humidité relative de 50 à 100 %.

De telles propriétés sont dues à la présence de la sous-couche d'implantation de carbone en gradient 14 qui constitue, entre le substrat 10 et la couche 18, une interface d'accrochage progressive qui retient mieux cette couche de carbone.

La couche de carbone 18 peut ensuite, selon les applications, être recouverte d'autres couches. La couche 18 constitue alors une barrière de diffusion très efficace, évitant la pénétration d'éléments qui compromettent la tenue de la couche rajoutée.

Il faut, enfin, noter que les opérations d'implantation et de dépôt se font à une température qui est, sensiblement, la température ambiante mais, en tout cas, inférieure à 80°C. De ce fait, contrairement aux procédés actuellement utilisés qui exigent des températures de quelque 800°C, les propriétés du substrat ne sont pas affectées par les élévations de température.

La technique selon l'invention, qui vient d'être décrite, est particulièrement bien adaptée au traitement de pièces de petites dimensions, notamment utilisées en microtechnique et dans l'industrie horlogère qui, comme les roues d'échappement des montres mécaniques, possèdent des dents dont on exige des propriétés de dureté et d'auto-lubrification extrêmement sévères. Les pointes et les arêtes de ces pièces peuvent, très avantageusement, bénéficier des avantages que procure l'invention puisque la couche de carbone auto-lubrifiante qui les revêt est à la fois très mince, très résistante et très dure.

Comme le montre la figure 3, il est avantageux que, pendant les opérations de bombardement de la pièce à traiter 10, celle-ci soit animée d'un mouvement de rotation autour d'un axe sensiblement perpendiculaire à la direction du faisceau d'ions.

Dans certaines applications, le bombardement de la pièce à partir d'une cathode en graphite peut être accompagné d'un bombardement, à l'aide d'une deuxième, voire d'une troisième, source(s) d'ions identique(s) à la première, à partir d'une cathode capable d'émettre, par exemple, des ions de titane ou de silicium.

Enfin, lorsqu'il s'agit de traiter des pièces possédant des formes complexes, il est avantageux que le bombardement soit effectué à l'aide de plusieurs sources agissant selon des angles différents.

La présente description a été faite en se référant à l'utilisation d'une source d'ions à "arc filtré pulsé", mais il va de soi que toute autre source ayant des performances semblables peut aussi convenir à la mise en oeuvre de l'invention, notamment une source basée sur le phénomène connu sous la dénomination de "laser ablation" .

## Revendications

1. Procédé de revêtement de la surface d'un substrat d'une couche à la base de carbone, comprenant les étapes suivantes:
a) se munir d'un substrat (10) en un matériau présentant une affinité pour le carbone,
b) bombarder une face (12) de ce substrat (10) par un faisceau d'ions de carbone accélérés en réduisant progressivement la tension sous laquelle les ions de carbone sont accélérés pour créer sous ladite face (12) une zone d'implantation de carbone (14) présentant un gradient croissant en direction de cette face,
c) puis maintenir la tension d'accélération constante à son niveau réduit pendant une durée suffisante pour faire croître sur la zone d'implantation (14) une couche à base de carbone jusqu'à l'épaisseur désiré.

2. Procédé selon la revendication 1, **caractérisé en ce que** le matériau formant le substrat (10) est choisi parmi le fer, le chrome, le titane, le vanadium, le tantale, le tungstène, le molybdène et le nickel, ainsi que leurs oxydes, leurs nitrures et leurs alliages.

3. Procédé selon la revendication 2, **caractérisé en ce que** le substrat est en acier.

4. Procédé selon l'une des revendications 1 à 3, **caractérisé en ce que** le substrat est bombardé à l'aide d'un faisceau d'ions filtré de manière à contenir essentiellement des ions de carbone.

5. Procédé selon l'une des revendications 1 à 4, **caractérisé en ce que** le substrat est bombardé à partir d'une source d'ions dite à "arc filtré pulsé".

6. Procédé selon l'une des revendications 1 à 5, **caractérisé en ce que** le taux d'implantation de carbone varie de 0 % à 100 %.

7. Procédé selon l'une des revendications 1 à 6, **caractérisé en ce que**, pendant le bombardement du substrat, celui-ci est animé d'un mouvement de rotation.

8. Procédé selon l'une des revendications 1 à 7, **caractérisé en ce que** la zone superficielle (18) a une épaisseur inférieure à 300 nm.

9. Procédé selon la revendication 8, **caractérisé en ce que** la zone superficielle (18) a une épaisseur de l'ordre de 100 nm.

10. Procédé selon l'une des revendications 1 à 9, **caractérisé en ce que** la zone d'implantation (14) a une profondeur comprise entre 10 et 100 nm.

11. Procédé selon l'une des revendication 1 à 10, **caractérisé en ce que** le substrat est bombardé par plusieurs faisceaux d'ions le touchant sous des angles différents.

12. Procédé selon l'une des revendications 1 à 11, **caractérisé en ce que** le bombardement du substrat est accompagné d'un bombardement à partir d'une cathode capable d'émettre des ions de silicium ou de titane.

13. Procédé selon la revendication 12, **caractérisé en ce qu'**on dépose une couche comprenant du silicium sur la face (12) du substrat.

14. Procédé selon l'une des revendications précédentes, **caractérisé en ce que** le substrat est une pièce d'horlogerie.

15. Procédé selon la revendication 14, **caractérisé en ce que** la pièce d'horlogerie comprend des dents, pointes ou arêtes.

16. Procédé selon la revendication 15, **caractérisé en ce que** la couche à la base de carbone est formée que sur les dents, pointes ou arêtes.

## Patentansprüche

1. Verfahren zur Beschichtung einer Oberfläche eines Substrats mit einer Schicht auf der Basis von Kohlenstoff umfassend die folgenden Schritte des:
a) zur-Verfügung-stellens eines Substrats (10) aus einem Material, das eine Affinität für Kohlenstoff aufweist
b) Bombardierens einer Fläche (12) dieses Substrats (10) mit einem Strahl aus beschleunigten Kohlenstoffionen, indem man nach und nach die Spannung mit der die Kohlenstoffionen beschleunigt werden, reduziert, um auf der Fläche (12) eine Implantationszone von Kohlenstoff (14) zu erzeugen, die einen zunehmenden Gradient in Richtung zu dieser Fläche aufweist, und
c) des konstanten Beibehaltens der Beschleunigungsspannung auf ihrem verminderten Niveau während eines Zeitraums, der ausreichend ist, um auf der Implantationszone (14) eine Schicht auf Basis von Kohlenstoff bis zur gewünschten Dicke wachsen zu lassen.

2. Verfahren gemäß Anspruch 1, **dadurch gekennzeichnet, dass** das Material das das Substrat (10) bildet, ausgewählt ist aus Eisen, Chrom, Titan, Vanadium, Tantal, Wolfram, Molybdän und Nickel und ihren Oxiden, ihren Nitriden und ihren Legierungen.

3. Verfahren nach Anspruch 2, **dadurch gekennzeichnet, dass** das Substrat aus Stahl ist.

4. Verfahren nach einem der Ansprüche 1 bis 3, **dadurch gekennzeichnet, dass** das Substrat mit Hilfe eines Ionenstrahls bombardiert wird, der gefiltert ist, so dass er im Wesentlichen Kohlenstoffionen enthält.

5. Verfahren nach einem der Ansprüche 1 bis 4, **dadurch gekennzeichnet, dass** das Substrat ausgehend von einer Ionenquelle, die "gepulster gefilterter Bogen" genannt wird, bombardiert wird.

6. Verfahren nach einem der Ansprüche 1 bis 5, **dadurch gekennzeichnet, dass** der Grad der Implantation an Kohlenstoff zwischen 0 bis 100 % variiert.

7. Verfahren nach einem der Ansprüche 1 bis 6, **dadurch gekennzeichnet, dass** während des Bombardements, das Substrat durch eine Rotationsbewegung bewegt wird.

8. Verfahren nach einem der Ansprüche 1 bis 7, **dadurch gekennzeichnet, dass** die Oberflächenzone (18) eine Dicke von weniger als 300 nm aufweist.

9. Verfahren nach Anspruch 8, **dadurch gekennzeichnet, dass** die Oberflächenzone (18) eine Dicke in der Größenordnung von 100 nm aufweist.

10. Verfahren nach einem der Ansprüche 1 bis 9, **dadurch gekennzeichnet, dass** die Implantationszone (14) eine Tiefe zwischen 10 und 100 nm aufweist.

11. Verfahren nach einem der Ansprüche 1 bis 10, **dadurch gekennzeichnet, dass** das Substrat mit mehreren Ionenstrahlen bombardiert wird, die es unter verschiedenen Winkeln treffen.

12. Verfahren nach einem der Ansprüche 1 bis 11, **dadurch gekennzeichnet, dass** das Bombardement des Substrats von einem Bombardement ausgehend von einer Kathode begleitet wird, die in der Lage ist, Silizium oder Titanionen zu emittieren.

13. Verfahren nach Anspruch 12, **dadurch gekennzeichnet, dass** man eine Schicht umfassend Silicium auf die Oberfläche (12) des Substrats abscheidet.

14. Verfahren nach einem der vorhergehenden Ansprüche, **dadurch gekennzeichnet, dass** das Substrat Teil eines Uhrwerkes ist.

15. Verfahren nach Anspruch 14, **dadurch gekennzeichnet, dass** das Teil des Uhrwerkes, Zähne, Spitzen oder Kanten umfasst.

16. Verfahren nach Anspruch 15, **dadurch gekennzeichnet, dass** die Schicht auf der Grundlage von Kohlenstoff auf den Zähnen, Spitzen oder Kanten gebildet wird.

## Claims

1. Process for the coating of a surface of a substrate with a layer on the basis of carbon, comprising the following steps:
a) providing a substrate (10) of a material which has an affinity for carbon,
b) bombarding one face (12) of the substrate (10) with a beam of accelerated carbon ions by reducing progressively the voltage by which the carbon ions are accelerated to generate below this face (12) a carbon implantation zone (14) which presents a gradient increasing in the direction to this face, and
c) maintaining constant the acceleration voltage on the reduced level during a time period which is sufficient to grow on the implantation zone (14) a layer on the basis of carbon until the desired thickness.

2. Process according to claim 1, **characterized in that** the material which forms the substrate (10) is selected from iron, chromium, titanium, vanadium, tantalum, tungsten, molybdenum and nickel as well as oxides, nitrides and alloys thereof.

3. Process according to claim 2, **characterized in that** the substrate is steel.

4. Process according to any one of the claims 1 to 3, **characterized in that** the substrate is bombarded with an ion beam, filtered, in such a manner as to contain essentially carbon ions.

5. Process according to any one of the claims 1 to 4, **characterized in that** the substrate is bombarded from an ion source termed as "pulsed filtered arc".

6. Process according to any one of the claims 1 to 5, **characterized in that** the degree of implantation of carbon varies from 0 % to 100 %.

7. Process according to any one of the claims 1 to 6, **characterized in that** during the bombardment of the substrate, the substrate is incited by a rotating movement.

8. Process according to any one of the claims 1 to 7, **characterized in that** the superficial zone (18) has a thickness less than 300 nm.

9. Process according to claim 8, **characterized in that** the zone on the surface (18) has a thickness in the range of 100 nm.

10. Process according to any one of the claims 1 to 9, **characterized in that** the implantation zone (14) has a depth which is comprised between 10 and 100 nm.

11. Process according to any one of the claims 1 to 10, **characterized in that** the substrate is bombarded by several ion beams which are touching it under different angles.

12. Process according to any one of the claims 1 to 11, **characterized in that** the bombardment of the substrate is accompanied by a bombardment from a cathode which can emit silicon or titanium ions.

13. Process according to claim 12, **characterized in that** a layer comprising silicon is deposited the face (12) of the substrate.

14. Process according to any one of the preceding claims, **characterized in that** the substrate is a wheel work piece.

15. Process according to claim 14, **characterized in that** the wheel work piece comprises teeth, points or edges.

16. Process according to claim 15, **characterized in that** the layer on the basis of carbon is formed on the teeth, points or edges.
